(19) Europäisches Patentamt
European Patent Office
Office européen des brevets

(11) **EP 2 685 574 B1**

(12) **FASCICULE DE BREVET EUROPEEN**

(45) Date de publication et mention de la délivrance du brevet:
**04.03.2015 Bulletin 2015/10**

(51) Int Cl.:
*H01S 3/0941* (2006.01)   *H01S 3/063* (2006.01)
*H01S 3/094* (2006.01)    *H01S 3/10* (2006.01)
*H01S 3/23* (2006.01)     *H01S 5/14* (2006.01)

(21) Numéro de dépôt: **13176152.0**

(22) Date de dépôt: **11.07.2013**

(54) **Système d'émission de signal optique**

System zum Ausstrahlen eines optischen Signals

System for emitting an optical signal

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.07.2012 FR 1201997**

(43) Date de publication de la demande:
**15.01.2014 Bulletin 2014/03**

(73) Titulaires:
• **Thales**
  **92200 Neuilly Sur Seine (FR)**
• **Centre National de la Recherche Scientifique**
  **75016 Paris (FR)**

(72) Inventeurs:
• **Nappez, Thomas**
  **26027 VALENCE (FR)**
• **Rondeau, Philippe**
  **26400 ALLEX (FR)**
• **Schlotterbeck, Jean-Pierre**
  **26300 ROCHEFORT-SAMSON (FR)**
• **Ghibaudo, Elise**
  **38000 GRENOBLE (FR)**
• **Broquin, Jean-Emmanuel**
  **38000 GRENOBLE (FR)**

(74) Mandataire: **Brunelli, Gérald**
**Marks & Clerk France**
**Immeuble Visium**
**22, avenue Aristide Briand**
**94117 Arcueil Cedex (FR)**

(56) Documents cités:
**WO-A1-95/21480     WO-A2-02/065600**
**GB-A- 2 298 082**

• **V. DONZELLA ET AL: "lon-exchanged Er^3+/Yb^3+ co-doped waveguide amplifiers longitudinally pumped by broad area lasers", OPTICS EXPRESS, vol. 18, no. 12, 28 mai 2010 (2010-05-28), page 12690, XP055014043, DOI: 10.1364/OE.18.012690**
• **LYDIE ONESTAS ET AL: "980nm-1550nm vertically integrated duplexer for hybrid erbium-doped waveguide amplifiers on glass", PROCEEDINGS OF SPIE, 1 janvier 2009 (2009-01-01), page 721805, XP055013876, DOI: 10.1117/12.811381**
• **THOMAS NAPPEZ ET AL: "<title>Broad-area laser diode with stable single-mode output and wavelength stabilization</title>", PROCEEDINGS OF SPIE, vol. 8264, 9 février 2012 (2012-02-09), page 82640W, XP055054196, ISSN: 0277-786X, DOI: 10.1117/12.907796**
• **HASEGAWA T ET AL: "POLARIZATION INDEPENDENT FREQUENCY CONVERSION BY FIBER FOUR-WAVE MIXING WITH A POLARIZATION DIVERSITY TECHNIQUE", IEEE PHOTONICS TECHNOLOGY LETTERS, IEEE SERVICE CENTER, PISCATAWAY, NJ, US, vol. 5, no. 8, 1 août 1993 (1993-08-01), pages 947-949, XP000399656, ISSN: 1041-1135, DOI: 10.1109/68.238264**

**Description**

La présente invention porte sur un système d'émission de signal optique, et notamment les amplificateurs optiques à gain élevé.

Il est connu des systèmes d'émission de signal optique, ou injecteurs optiques, dont l'émission est à la fois stable, monomode et monofréquence, dont la puissance d'émission est limitée à quelques dizaines de milliwatts.

Cette limitation est particulièrement forte autour de la longueur d'onde de 1,55 $\mu$m, souvent employé pour sa sécurité oculaire.

Les applications qui nécessitent une puissance plus importante, dans une gamme de puissance supérieure au watt optique, doivent utiliser au minimum deux étages d'amplification. Un premier étage d'amplification ou pré-amplificateur permet d'atteindre la gamme de puissance requise pour un signal de sortie qui est ensuite amplifié par un second étage d'amplification de manière à atteindre des puissances optiques supérieures au watt. Ces étages d'amplification nécessitent d'avoir chacun une interface propre : une source de pompe, un refroidisseur, un mélangeur, un séparateur et éventuellement un recycleur de pompe résiduelle.

La présence de ces deux étages d'amplification augmente fortement le coût et la taille de ses systèmes d'émission et impliquent un nombre élevé de connexions entre composants, ce qui réduit la fiabilité et complique la maintenance.

L'amplification à fort gain d'un signal monomode est généralement réalisée en optique guidée selon deux modes de réalisation bien connus, qui utilisent tous deux des diodes laser comme pompes, profitant ainsi de leurs compacité et de leur fiabilité

Le premier mode de réalisation connu consiste à utiliser une diode laser de pompe monomode fibrée. Ce mode de réalisation permet une amplification efficace car son émission est adaptée à l'émission du milieu amplificateur. En revanche la puissance de pompe pour un émetteur est limitée autour du watt optique, limitant la longueur du matériau amplificateur et donc le gain total de l'amplificateur. Afin d'obtenir une amplification à fort gain, plusieurs de ses diodes laser de pompe doivent être utilisées, ce qui diminue la compacité et augmente le coût, tant sur le prix d'achat des pompes que sur la consommation électrique nécessaire au refroidissement de chacune des pompes.

Le deuxième mode de réalisation connu et d'utiliser une ou plusieurs diodes laser à ruban large et d'adapter le milieu amplificateur à l'émission multimode de la diode laser de pompe. Il existe des fibres optiques à double coeur dans lesquelles seul un fin cylindre central est actif. Ainsi il est possible de générer un signal monomode autour de cette zone tandis que l'onde de pompe est guidée dans la partie cylindrique large entourant le fin cylindre central actif. Cependant, la faible interaction entre la pompe multimode et le signal monomode d'un tel mode de réalisation implique une grande longueur de fibre optique afin d'obtenir un gain total important.

Par ailleurs, les amplificateurs optiques nécessitent un mélangeur en entrée et un séparateur en sortie entre la pompe et le signal. Réalisés le plus souvent par fusion-étirage entre deux fibres optiques, ces composants diminuent la compacité des modules d'amplification.

En outre, il est parfois proposé d'apporter la pompe de chaque côté du milieu amplificateur afin d'obtenir un pompage homogène, limitant les éventuels effets parasites dus à une trop forte densité de puissance dans le milieu actif. Cependant, la puissance de pompe résiduelle qui sort de part et d'autre du milieu amplificateur peut se coupler dans chacune des diodes laser. Leur émission est perturbée, la puissance émise et la longueur d'onde peuvent alors sensiblement varier au cours du temps. Ces perturbations augmentent le bruit additionnel de l'amplificateur. Il peut alors s'avérer nécessaire d'utiliser un isolateur optique fibré coûteux en sortie de chaque diode laser de pompe.

Aussi, les modes de réalisation connus pour une amplification à fort gain manquent de compacité. Cette limitation est due aux pompes disponibles. Dans le cas de diodes laser monomodes, plusieurs émetteurs séparés doivent être utilisés, et dans le cas de diodes laser multimodes, une longueur de plusieurs mètres de milieu amplificateur doit être employée. De plus, l'ajout de mélangeur, de séparateur et d'isolateur intégré sur fibre optique contribue au manque de compacité du système.

Le document "Ion-exchanged Er3+/Yb3+ co-doped waveguide amplifiers longitudinally pumped by broad area lasers", V. DONZELLA ET AL, OPTICS EXPRESS vol. 18, no. 12, 28 mai 2010 page 12690, divulgue un système d'émission de signal optique comprenant une puce optique passive munie en surface supérieure d'un premier guide d'ondes, et une diode laser à ruban large disposée en bordure de la puce optique passive, la puce optique passive étant munie, en surface supérieure, d'une portion en couche mince active ou non-linéaire alimentée par ladite diode laser et recouvrant une partie du premier guide d'ondes, le premier guide d'ondes étant relié par son extrémité d'entrée à la diode laser, et comprenant une transition entre une entrée large du premier guide d'ondes disposée en sortie de la diode laser et une portion étroite du premier guide d'ondes, la puce optique passive étant munie en surface supérieure d'un deuxième guide d'ondes.

Un but de l'invention est de remédier au problème précédemment cité, et notamment de proposer un système d'amplification compact et un fort gain.

Aussi, il est proposé, selon un aspect de l'invention, un système d'émission de signal optique comprenant une puce optique passive munie en surface supérieure d'un premier guide d'ondes, et une diode laser à ruban large disposée en bordure de la puce optique passive. La puce optique passive est munie, en surface supérieure, d'une structure réfléchissante à la longueur d'onde de la diode laser à ruban large et d'une portion en couche mince active ou non-linéaire alimentée par ladite diode laser et recouvrant une partie du premier guide d'ondes. Le premier guide d'ondes étant relié par son extrémité d'entrée à la diode laser, traversant la structure réfléchissante, et comprenant une transition entre une entrée large du premier guide d'ondes disposée en sortie de la diode laser et une portion étroite du premier guide d'ondes traversant la structure réfléchissante. La puce optique passive est munie en surface supérieure d'un deuxième guide d'ondes, d'un premier coupleur formé par deux premières portions du premier guide d'ondes non recouvertes par la portion en couche mince et situées de part et d'autre de la portion en couche mince le long du chemin optique, et d'un deuxième coupleur formé par deux deuxièmes portions, respectivement des premier et deuxième guides d'ondes, non recouvertes par la portion en couche mince.

Un tel système permet d'avoir à la fois un gain élevé et une importante compacité. Le gain de compacité conduit de plus à une meilleure robustesse par rapport aux environnements vibratoires.

Dans un mode de réalisation, les extrémités d'entrée et de sortie des premier et deuxième guides d'ondes débouchant sur un bord de la puce optique passive sont disposées sur un même bord de la puce optique passive.

Ainsi on minimise le nombre de facettes devant être polies, et donc le coût du système.

Selon un mode de réalisation, les extrémités d'entrée et de sortie des premier et deuxième guides d'ondes débouchant sur un bord de la puce optique sont disposées à distance de la diode laser.

Ainsi les extrémités d'entrée et de sortie des premier et deuxième guides d'ondes sont éloignés de la source de chaleur que représente la diode laser minimisant les contraintes thermiques au niveau des couplage avec les fibres optiques d'insertion du signal et d'extraction du signal amplifié et augmentant par conséquent la fiabilité du composant.

Dans un mode de réalisation, la puce optique passive est munie en surface supérieure d'un troisième guide d'ondes, d'un troisième coupleur formé par deux troisièmes portions, respectivement des deuxième et troisième guides d'ondes, non recouvertes par la portion en couche mince, et d'un module de détection équilibrée relié aux extrémités de sortie des deuxième et troisième guides d'ondes en bordure de la puce optique passive.

Ainsi il est possible d'obtenir une détection hétérodyne équilibrée dont le principal avantage est de supprimer les composantes dues aux variations d'intensité de l'onde d'oscillateur local transporté par le troisième guide d'onde dans le signal électrique obtenu en sortie du détecteur. La forte compacité du module obtenu permet une meilleure stabilité de l'équilibrage et permet une meilleure réjection des composantes parasites jusqu'à des fréquences élevées.

Selon un mode de réalisation, la partie du premier guide d'ondes, recouverte par la portion en couche mince, est enroulée.

Ainsi, l'encombrement du premier guide d'onde est minimisée et le composant complet obtenu peut être réalisé sur des substrats de faibles dimensions.

Par exemple, le rayon de courbure en tout point de la partie enroulée du premier guide d'ondes est supérieur à 1 mm.

Ainsi, le pertes de transmission du guide d'onde sont minimisée pour un confinement de l'onde guidée autorisant de tels rayons de courbures du guide d'onde.

Dans un mode de réalisation, la transition est adiabatique.

L'utilisation d'une transition adiabatique, permet d'augmenter le rendement global.

Selon un mode de réalisation, la diode laser comprend une facette de sortie ayant subi un traitement anti-réflexion.

Ainsi, la réflexion nécessaire à ladite structure réfléchissante pour verrouiller ladite diode laser diminue et la puissance en sortie du guide d'ondes traversant ladite structure réfléchissante est augmentée

Par exemple, ladite structure réfléchissante comprend un réseau de Bragg, un cristal photonique, une interruption de guide d'ondes, une facette inclinée, ou toute autre structure permettant une réflexion optique contra-propagative.

Ainsi, la lumière confinée dans le guide d'onde traversant la structure réfléchissante interagit avec ladite structure réfléchissante, est réfléchie sur elle même et revient au sein de ladite diode laser. Ladite diode laser est alors verrouillée sur le ou les modes supportés par ledit guide d'ondes étroit traversant ladite structure réfléchissante.

Dans le cas d'une réflexion spectralement fine, la longueur d'ondes d'émission de ladite diode laser est stabilisée sur la réflexion spectrale de ladite structure réfléchissante.

L'invention sera mieux comprise à l'étude de quelques modes de réalisation décrits à titre d'exemples nullement limitatifs et illustrés par les dessins annexés sur lesquels :

- les figures 1 à 7 illustrent schématiquement plusieurs modes de réalisation d'un système selon divers aspects de l'invention;
- les figures 8 et 9 illustrent schématiquement le gain obtenu en fonction de la puissance; et
- la figure 10 illustre schématiquement le gain en fonction de la puissance signal pour une longueur de 25 cm et une pompe de 2 W.

EP 2 685 574 B1

Sur l'ensemble des figures, les éléments ayants les mêmes références sont similaires.

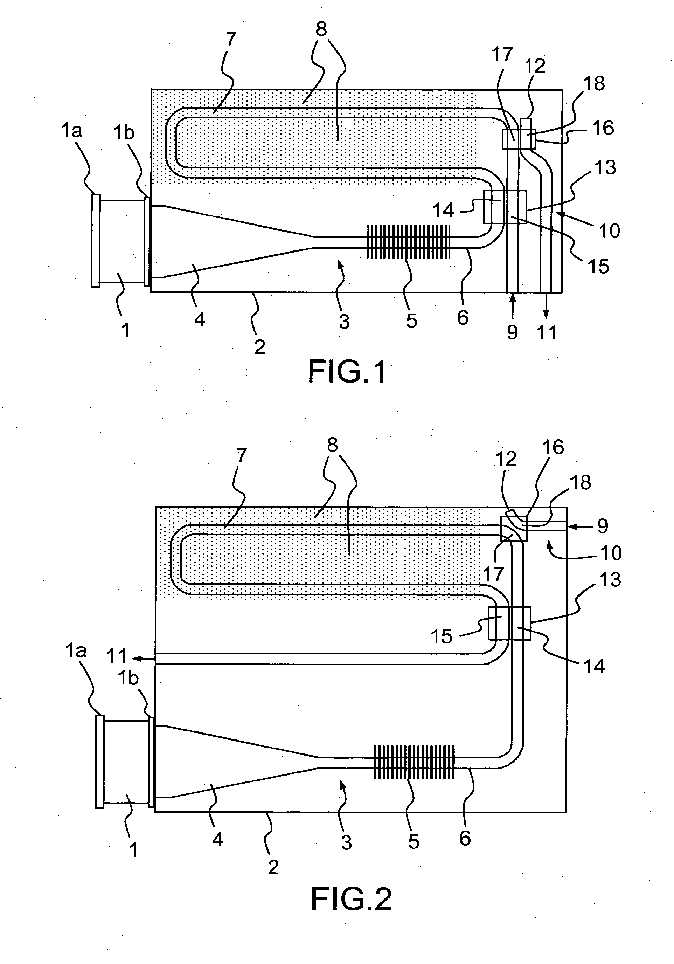

Tel qu'illustré sur la figure 1, le système d'émission de signal optique comprend une diode laser 1 munie d'une facette d'entrée 1 a et d'une facette de sortie 1 b montée en contact sur une facette d'entrée d'une puce optique passive 2. La puce optique passive 2 comprend, en surface supérieure, un premier guide d'ondes 3 comprenant un épanouisseur ou transition adiabatique 4 reliée en entrée à la facette de sortie 1 b de la diode laser 1, de sortie étroite, traversant une structure réfléchissante 5 à la longueur d'onde de la diode laser à ruban large 1. Cette portion du premier guide d'ondes 3 forme un transformateur modal qui se termine par un guide d'ondes monomode 6.

Ensuite, le premier guide d'ondes 3 comprend une partie 7 recouverte d'une portion en couche mince 8, active ou non linéaire alimentée par la diode laser 1. Ensuite, après avoir traversé la portion en couche mince 8, le premier guide d'ondes 3 continue et se termine par une extrémité de sortie 9 débouchant sur un bord de la puce optique passive 2.

En outre, la puce optique passive 2 comprend, en surface supérieure, un deuxième guide d'ondes 10 comprenant une extrémité d'entrée 11 débouchant sur un bord de la puce optique passive 2 et une extrémité d'entrée 12.

La puce optique passive 2 est munie, en surface supérieure, d'un premier coupleur 13 formé par deux premières portions 14 et 15 du premier guide d'ondes 3, non recouvertes par la portion en couche mince 8 et situées de part et d'autre de la portion en couche mince 8 le long du chemin optique, et d'un deuxième coupleur 16 formé par deux deuxièmes portions 17 et 18, respectivement des premier et deuxième guides d'ondes 3 et 10, non recouvertes par la portion en couche mince 8.

La figure 1 illustre l'utilisation du premier coupleur 13 comme séparateur pompe/signal. Le signal à amplifier entre par l'extrémité 9 du premier guide d'ondes 3 et sort, après amplification, par l'extrémité 11 du deuxième guide d'ondes 10.

Bien entendu, une telle architecture permet également d'avoir le signal à amplifier qui entre par l'extrémité 11 du deuxième guide d'ondes 10 et qui sort par l'extrémité 9 du premier guide d'ondes 3.

L'architecture représentée sur la figure 1 est réalisée sur la base d'un substrat passif 2 et d'un substrat actif 8, tous deux comprenant du verre, de manière préférentielle.

L'architecture représentée présente trois parties. La première partie comprend la diode laser à ruban large 1, appelée également diode de pompe dans le reste du présent document, et est couplée à l'entrée du transformateur modal formé de la transition adiabatique 4 du premier guide d'ondes 3 traversant la structure réfléchissante 5 se terminant par une portion en guide d'ondes monomode 6 aux longueurs d'ondes de pompe et de signal sur lequel est intégrée la structure réfléchissante 5, par exemple un réseau de Bragg 5. La longueur d'onde de Bragg est choisie pour être située dans la bande de gain de la diode de pompe 1 et dans la bande d'absorption du substrat actif 8. Le réseau de Bragg 5 crée une activité externe planaire à la diode de pompe 1 et impose une rétroaction monomode et sélective en longueur d'ondes au sein de la diode de pompe 1. Ainsi, lorsque la réflexion du réseau de Bragg 5 est choisie de manière à imposer les conditions d'oscillations laser à la diode de pompe 1, initialement obtenues par ses facettes d'entrée et de sortie, on obtient une émission puissante, monomode et stabilisée en longueur d'onde de la diode de pompe 1, initialement puissante mais multimode. Cette première partie comprend également le premier coupleur 13 dont deux branches sont reliées à la deuxième partie.

La deuxième partie comprend une portion 7 du premier guide d'ondes 3, en l'espèce une boucle 7, reliant les deux branches de sortie du premier coupleur 13. Le milieu amplificateur 8, ou portion en couche mince 8, active ou non linéaire alimentée par la diode laser 1, est formé sur une partie de la boucle 7. Le milieu amplificateur 8 est préférentiellement une couche mince d'un verre actif reporté par adhésion moléculaire sur le substrat passif 2, permettant un guidage hybride au sein de la portion en couche mince 8 où la portion 7 du premier guide d'ondes 3 est présente. Le premier coupleur 13 est dimensionné pour offrir, sur un aller simple, un couplage de 3 dB à la longueur d'onde de la diode de pompe 1 verrouillée par le réseau de Bragg 5. Ainsi, la longueur d'onde de pompe est symétriquement injectée dans le guide amplificateur constitué par la portion 7 du premier guide d'ondes 3 en contact avec le milieu amplificateur 8. En outre, la pompe résiduelle sortant de part et d'autre du guide amplificateur 7 et arrivant sur chacune des branches du premier coupleur 13 se couple entièrement dans la branche par laquelle elle est arrivée. En effet, les deux ondes de pompe séparées par le premier coupleur, ont parcouru le même chemin optique, aussi le déphasage entre elles n'est dû qu'au déphasage induit par le premier coupleur 13. Les deux ondes résiduelles sont donc en quadrature de phase en arrivant sur le premier coupleur 13 et toute la puissance est donc transmise vers la branche par laquelle la pompe est amenée. Ainsi, le réseau de Bragg 5 permet de recycler, à hauteur de sa réflectivité, la pompe dans le milieu amplificateur 8. Lorsque la facette 1 b de la diode de pompe 1 n'a pas subi de traitement anti-réflexion, la réflexion du réseau de Bragg 5 nécessaire au verrouillage de la diode laser 1 est importante. Ainsi, cette forte réflectivité isole la diode de pompe 1 de tout retour lumineux tout en recyclant efficacement la pompe résiduelle dans le milieu amplificateur 8. Le premier coupleur 13 est également dimensionné pour offrir un transfert complet du signal, comme illustré sur la figure 1, ou, en variante, comme illustré sur la figure 2, pour n'offrir aucun couplage d'une branche à l'autre pour la longueur d'onde du signal à amplifier. Ainsi, le premier coupleur 13 permet, dans le cas de la figure 1, de mélanger directement la pompe et le signal, ce qui permet d'éviter la présence d'un composant nécessaire aux modules d'amplification. En revanche en outre, dans le cas de la figure 2, le premier coupleur 13 permet de séparer directement la pompe du signal, ce qui permet également d'éviter la présence d'un composant nécessaire aux modules d'amplification. L'extrémité 11 du deuxième guide d'ondes 10 comporte donc uniquement le signal amplifié et constitue la sortie du système.

La troisième partie concerne, dans le cas de la figure 1, l'extrémité 11 du deuxième guide d'ondes, par laquelle sort le signal amplifié, et son séparateur, ou deuxième coupleur 16, d'avec la pompe.

Dans la présente description, la conception des coupleurs est telle qu'il est plus simple de les considérer comme des boîtes noires reliant deux guides d'ondes d'un coté à deux guides d'ondes de l'autre coté (les termes d'entrées/sorties n'ont pas de réel sens, mais servent à différencier les côtés. Les coupleurs ne sont pas orientés). Toute onde arrivant sur un guide d'ondes d'un coté d'un coupleur est divisée en deux ondes sur les deux guides d'ondes, de l'autre coté, avec un coefficient de séparation et une phase (entre la sortie qui est en face du guide d'ondes d'injection et celle qui n'est pas en face) qui dépend des caractéristiques du coupleur, de la polarisation de l'onde et de sa longueur d'onde. Ces coupleurs peuvent donc servir de mélangeurs, de séparateurs, ou de duplexeur/séparateurs de longueur d'onde selon les besoins. Au sein du coupleur, l'onde n'est pas confinée dans son guide d'insertion.

Dans le cas de la figure 2, la troisième partie concerne l'extrémité 9 par laquelle entre le signal amplifié, et son mélangeur, ou deuxième coupleur 16, avec la pompe.

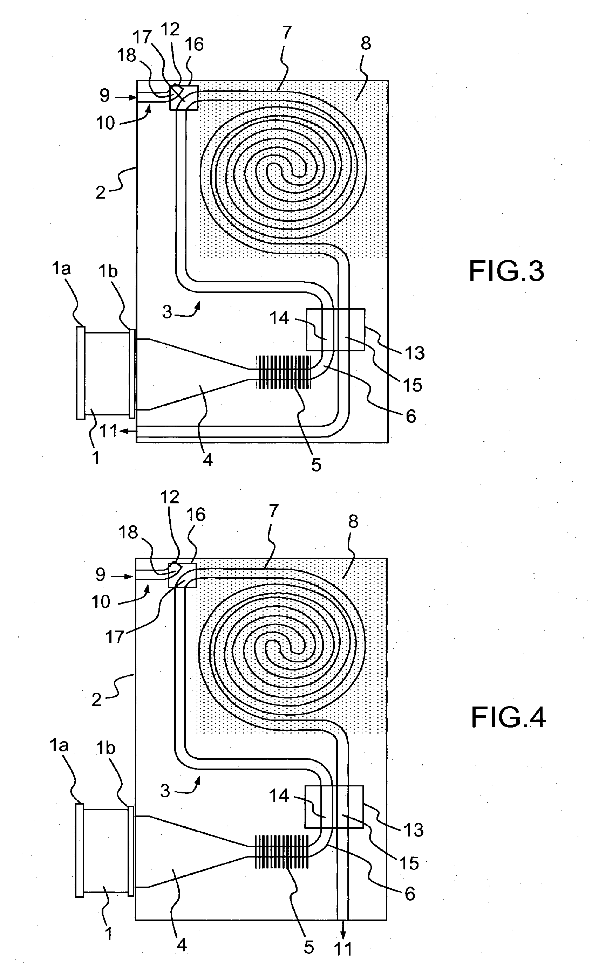

Les figures 3, 4, et 5 illustrent des modes de réalisation permettant d'augmenter la longueur du milieu amplificateur.

Comme illustré sur la figure 3, il est possible d'enrouler la partie 7 du premier guide d'onde 3 recouverte par la zone amplificatrice 8, et ainsi augmenter très fortement la longueur du milieu amplificateur. Il est ainsi possible de dimensionner cette longueur et la puissance fournie par la diode de pompe 1 de manière à obtenir un gain total supérieur pour le système.

Le mode de réalisation représenté sur la figure 3 permet d'avoir les deux signaux à injecter (pompe et signal amplifié) ainsi que le signal de sortie (signal amplifié) situé sur une même bordure de la puce optique passive 2. Les facettes ayant besoin être polies lors de la fabrication du système sont donc minimisées.

Le mode de réalisation représenté sur la figure 4, dans lequel la sortie du système module d'amplification est située sur une autre bordure de la puce optique passive 2 que celle comprenant la diode laser diode de pompe 1, facilite la connexion d'une fibre pour l'extraction du signal amplifié.

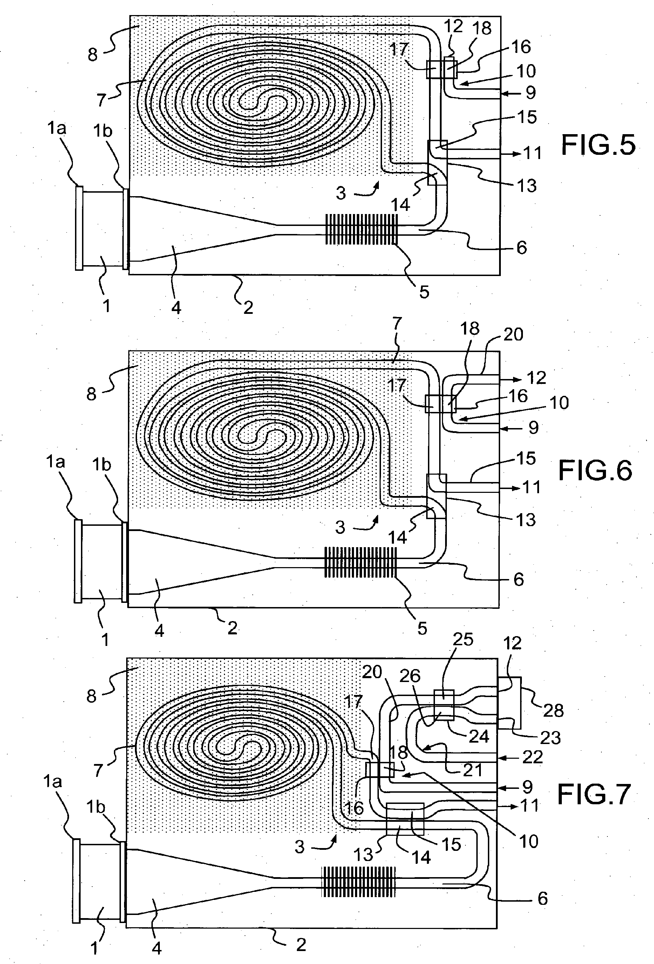

Le mode de réalisation représentée sur la figure 5, dans lequel l'entrée et la sortie du milieu actif 8 sont placées sur un même côté du milieu actif 8, ce qui permet d'avoir un seul côté du milieu actif 8 adapté à la transition entre les milieux actif 8 et passif 2, et ainsi faciliter la production du module.

En effet, dans la partie recouverte par le milieu à gain, le guide doit être en surface pour que l'onde puisse interagir avec le milieu à gain 8 alors que dans le reste de la plaque 3 les guides doivent être enterrés (pour limiter les pertes par diffusion sur la surface de la plaque). La transition entre le guide en surface et le guide enterré demande un procédé spécial de réalisation et il est plus simple d'avoir les deux transition sur le même axe.

Les figures 6 et 7 illustrent deux modes de réalisation particulièrement utiles à la télédétection par laser ou LiDAR pour acronyme de l'expression en langue anglaise "light détection and ranging".

Dans le mode de réalisation de la figure 6, on utilise un transfert partiel de l'entrée 9 du signal vers le milieu amplificateur 8 grâce au deuxième coupleur 16. Une voie d'oscillateur local 20 est alors créée en utilisant le deuxième coupleur 16 déjà présent.

Dans le mode de réalisation de la figure 7, on ajoute un troisième guide d'ondes 21 d'extrémités 22 et 23, un troisième coupleur 24 formé par deux troisième portion 25 et 26 respectivement du deuxième guide d'ondes 10 et du troisième guide d'ondes 21, et un détecteur équilibré 26 pour réaliser une détection équilibrée auto-hétérodyne. Les extrémités 12 et 23 des deuxième et troisième guide d'ondes 10 et 21 arrivent sur deux photodiodes du détecteur équilibré 26.

Les approches et les écartements des branches des trois coupleurs 13, 16 et 24 sont identiques, facilitant leur dimensionnement. La partie 7 enroulée utilise une technologie permettant un rayon de courbure pour les guides d'ondes jusqu'à 1 mm. Le rayon de courbure peut varier en fonction du confinement des modes guidés donnés par la technologie employée. Plus le confinement est important, plus le rayon de courbure peut être petit.

Préférentiellement, le verre passif peut être un verre silicate, et le verre actif peut être un verre phosphate dopé terres rares.

Afin de garantir son adiabaticité, la longueur L de la transition 4 doit satisfaire le critère suivant :

$$L \geq \frac{W^2}{\lambda^{m=0}}$$

dans lequel W représente la largeur de l'entrée de la transition 4 et $\lambda^{m=0}$ la longueur d'onde du mode fondamental dans le milieu.

Si W = 100 $\mu$m, $\lambda_0$ = 0,98 $\mu$m et $n_{eff}$ = 1,5, une longueur de transition de L=2 cm est suffisante pour satisfaire ce critère.

La longueur du réseau de Bragg 5 vaut classiquement environ un centimètre, ce qui porte l'extension minimale de la puce 2 dans le sens de l'épanouisseur 4 à 3 cm. Par exemple, pour une longueur de 4 cm, un rayon de courbure de 4 mm évite toute perte par rayonnement dans les courbures. En choisissant une longueur de couplage de 1 mm dans les trois coupleurs 13, 16 et 24, la zone disponible pour le milieu amplificateur 8 est de 2 cm dans la direction de l'épanouisseur 4, au vu de la configuration employée sur la figure 6. Lorsque l'enroulement est peu elliptique, la longueur du milieu amplificateur formé par l'enroulement 7 peut être approximée par :

$$L_{\text{act}} = 2\pi R + \pi \sum_{n=1}^{n=N} \sqrt{2\left[\left(2R + ns\right)^2 + \left(R + ns\right)^2\right]}$$

avec N le nombre de spires et s la distance séparant les guides voisins.

On suppose qu'une séparation s de 500 $\mu$m entre chacune des spires n'implique pas de couplage entre elles et laisse suffisamment d'espace pour pallier tout problème de dissipation de chaleur dans le système.

Les 2 cm du milieu amplificateur et cette séparation de 500 $\mu$m permettent d'obtenir une longueur de guides amplificateur 7 de 74 cm. L'autre axe de l'ellipse vaut alors 2,8 cm. Cette grande longueur de 74 cm est utile dans le cas où le milieu actif ne possède que peu d'absorption à la longueur d'onde de pompe, comme c'est le cas pour des verres dopés Erbium. Cependant dans le cas où l'application visée requiert un système plus compact, le verre phosphate est alors codopé Erbium/Ytterbium afin d'augmenter la section efficace d'absorption à la longueur d'onde de pompe.

Le calcul du gain disponible lorsque le système est réalisé par échange d'ions sur un verre phosphate dopé Erbium/Ytterbium peut être effectué comme suit.

On pose trois hypothèses :

i) les pertes par propagation intrinsèques dans le matériau aux longueurs d'onde de pompe et de signal sont de 0,1 dB/cm,

ii) la répartition d'intensité du mode de la pompe dans le milieu actif 8 a la forme d'une gaussienne circulaire de diamètre de 1/e valant 4 $\mu$m, et

iii) la répartition d'intensité du mode du signal est une gaussienne dont le diamètre est 8 $\mu$m.

Les simulations sont conduites pour une injection de la pompe d'un seul coté du système.

Les résultats sont présentés pour deux longueurs d'amplificateur 7 compatibles avec la place disponible : 50 cm et 25 cm.

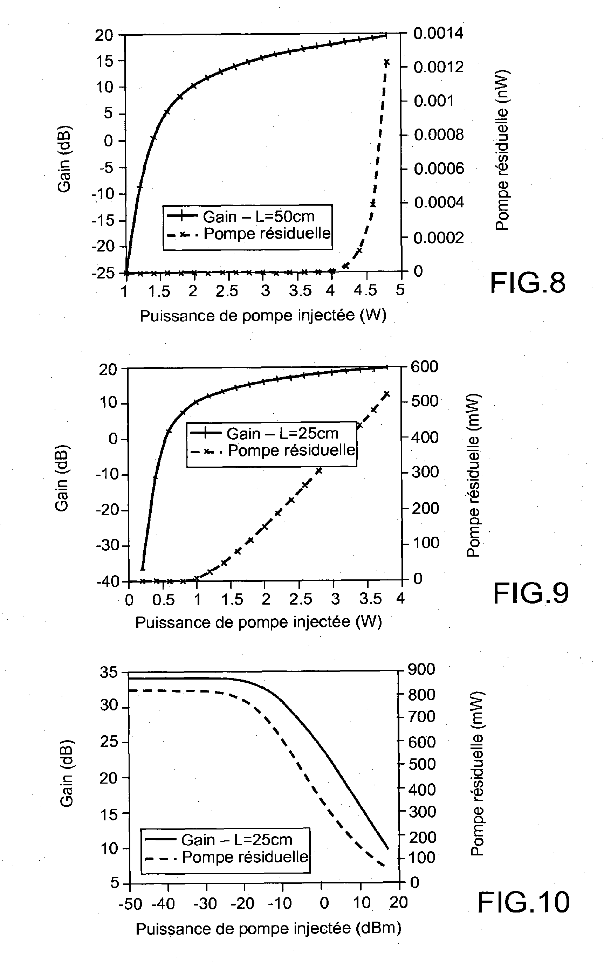

Les figures 8 et 9 présentent les résultats de simulation du gain obtenu en fonction de la puissance de pompe injectée dans le milieu actif 8 pour une puissance de signal en entrée de 10 mW.

La figure 7 concerne la longueur de guide amplificateur 7 de 50 cm, et la figure 8 concerne la longueur de guide amplificateur 7 de 25 cm.

Au vu des puissances de pompe actuellement disponibles pour une seule diode laser de pompe, une longueur de guide amplificateur 7 de 50 cm est trop importante. En effet un milieu aussi long implique une puissance de pompe de plus de 4,5 W afin de commencer à saturer l'amplificateur sur toute la longueur du guide amplificateur 7.

Une longueur de 25 cm est mieux adaptée. Ainsi une puissance de pompe de 4W donne une puissance signal en sortie de 1 W pour une puissance en entrée de 10mW.

Pour des puissances de pompe plus faibles, les simulations montrent l'intérêt de ce milieu pour amplifier des puissances d'entrée plus faibles.

La figure 10 décrit l'évolution du gain en fonction de la puissance de signal d'entrée injecté à l'extrémité 9 du guide d'onde pour une longueur du guide amplificateur 7 de 25 cm et une pompe de 2 W. Ce calcul montre notamment qu'une puissance entrée de 1 mW atteint 270 mW en sortie du système amplificateur et qu'une puissance d'entrée de 1 $\mu$W donne 2,5 mW en sortie.

Ce système peut être utilisé dans les domaines pour lesquels une amplification à fort gain est requise et des contraintes d'encombrement ne permettent pas d'utiliser les solutions classiques. Il peut être appliqué également lorsque l'on souhaite éviter la présence de fibres optiques, qui sont peu robustes aux vibrations mécaniques et qui peuvent parfois compliquer la maintenance.

Ainsi les systèmes embarqués, où l'encombrement est un paramètre extrêmement important, peuvent comprendre l'invention, et particulièrement les télédétecteurs par laser ou LiDAR.

Les procédés utilisés pour mettre en oeuvre l'invention peuvent faire appel à des technologies gravées ou diffusées selon les contraintes. Si on souhaite être naturellement compatible avec les fibres optiques, on préfère une technologie diffusée à faible saut d'indice. Si on souhaite une compatibilité naturelle avec la diode laser de pompe, on préfère une technologie à fort saut d'indice.

Dans un mode de réalisation préféré, on utilisera la technologie de l'échange d'ion sur verre, permettant de satisfaire les deux contraintes.

**Revendications**

1. Système d'émission de signal optique comprenant une puce optique passive (2) munie en surface supérieure d'un premier guide d'ondes (3), et une diode laser à ruban large (1) disposée en bordure de la puce optique passive (2), la puce optique passive (2) étant munie, en surface supérieure, d'une structure réfléchissante (5) à la longueur d'onde de la diode laser à ruban large (1) et d'une portion en couche mince (8) active ou non-linéaire alimentée par ladite diode laser (1) et recouvrant une partie (7) du premier guide d'ondes (3), le premier guide d'ondes (3) étant relié par son extrémité d'entrée à la diode laser (1), traversant la structure réfléchissante (5), et comprenant une transition (4) entre une entrée large du premier guide d'ondes disposée en sortie de la diode laser (1) et une portion étroite du premier guide d'ondes (3) traversant la structure réfléchissante (5), la puce optique passive (2) étant munie en surface supérieure d'un deuxième guide d'ondes (10), d'un premier coupleur (13) formé par deux premières portions (14,15) du premier guide d'ondes (3) non recouvertes par la portion en couche mince (8) et situées de part et d'autre de la portion en couche mince (8) le long du chemin optique, et d'un deuxième coupleur (16) formé par deux deuxièmes portions (17, 18), respectivement des premier et deuxième guides d'ondes (3,10), non recouvertes par la portion en couche mince (8).

2. Système selon la revendication 1, dans lequel les extrémités d'entrée et de sortie des premier et deuxième guides d'ondes (3, 10) débouchant sur un bord de la puce optique passive (2) sont disposées sur un même bord de la puce optique passive (2).

3. Système selon la revendication 1 ou 2, dans lequel les extrémités d'entrée et de sortie des premier et deuxième guides d'ondes (3, 10) débouchant sur un bord de la puce optique (2) sont disposées à distance de la diode laser (1).

4. Système selon l'une des revendications précédentes, dans lequel la puce optique passive (2) est munie en surface supérieure d'un troisième guide d'ondes (21), d'un troisième coupleur (24) formé par deux troisièmes portions (25,26), respectivement des deuxième et troisième guides d'ondes (10,24), non recouvertes par la portion en couche mince (8), et d'un module de détection équilibrée (26) relié aux extrémités de sortie des deuxième et troisième guides d'ondes (10,24) en bordure de la puce optique passive (2).

5. Système selon l'une des revendications précédentes, dans lequel la partie (7) du premier guide d'ondes (3), recouverte par la portion en couche mince (8), est enroulée.

6. Système selon la revendication 5, dans lequel le rayon de courbure de la partie enroulée (7) du premier guide d'ondes (3) est supérieur à 1 mm.

7. Système selon l'une des revendications précédentes, dans lequel la transition (4) est adiabatique.

8. Système selon l'une des revendications précédentes, dans lequel la diode laser (1) comprend une facette de sortie (1 b) ayant subi un traitement anti-réflexion.

9. Système selon l'une des revendications précédentes, dans lequel ladite structure réfléchissante (5) comprend un réseau de Bragg, un cristal photonique, une interruption de guide d'ondes, une facette inclinée, ou toute autre structure permettant une réflexion optique contra-propagative.

**Patentansprüche**

1. System zum Senden eines optischen Signals, das Folgendes umfasst: einen passiven optischen Chip (2), auf seiner Oberseite versehen mit einem ersten Wellenleiter (3) und eine an der Peripherie des passiven optischen Chips (2) angeordnete Breitbandlaserdiode (1), wobei der passive optische Chip (2) auf seiner Oberseite mit einer auf der Wellenlänge der Breitbandlaserdiode (1) reflektierenden Struktur (5) und mit einem aktiven oder nichtlinearen Dünnschichtabschnitt (8) versehen ist, der von der Laserdiode (1) gespeist wird und einen Teil (7) des ersten Wellenleiters (3) bedeckt, wobei der erste Wellenleiter (3) mit der Laserdiode (1) an deren Eingangsende verbunden ist, die reflektierende Struktur (5) durchquert und einen Übergang (4) zwischen einem breiten Eingang des ersten Wellenleiters am Ausgang der Laserdiode (1) und einem schmalen Abschnitt des ersten Wellenleiters (3) umfasst, der die reflektierende Struktur (5) durchquert, wobei der passive optische Chip (2) auf seiner Oberseite versehen ist mit einem zweiten Wellenleiter (10), einem ersten Koppler (13), der von zwei ersten Abschnitten (14, 15) des ersten Wellenleiters (3) gebildet wird, die nicht von dem Dünnschichtabschnitt (8) bedeckt werden und sich auf beiden Seiten des Dünnschichtabschnitts (8) entlang dem optischen Pfad befinden, und einem zweiten Koppler (16), der von zwei nicht von dem Dünnschichtabschnitt (8) bedeckten zweiten Abschnitten (17, 18) jeweils des ersten und zweiten Wellenleiters (3, 10) gebildet wird.

2. System nach Anspruch 1, wobei die Ein- und Ausgangsenden des ersten und zweiten Wellenleiters (3, 10), die an einem Rand des passiven optischen Chips (2) münden, am selben Rand des passiven optischen Chips (2) angeordnet sind.

3. System nach Anspruch 1 oder 2, wobei die Ein- und Ausgangsenden des ersten und zweiten Wellenleiters (3, 10), die an einem Rand des optischen Chips (2) münden, in einem Abstand von der Laserdiode (1) angeordnet sind.

4. System nach einem der vorherigen Ansprüche, wobei der passive optische Chip (2) auf einer Oberseite versehen ist mit einem dritten Wellenleiter (21), einem dritten Koppler (24), der von zwei dritten Abschnitten (25, 26) jeweils des zweiten und dritten Wellenleiters (10, 24) gebildet wird, die nicht von dem dünnschichtigen Abschnitt (8) bedeckt werden, und einem ausgeglichenen Detektionsmodul (26), das mit den Ausgangsenden des zweiten und dritten Wellenleiters (10, 24) an der Peripherie des passiven optischen Chips (2) verbunden ist.

5. System nach einem der vorherigen Ansprüche, wobei der von dem dünnschichtigen Abschnitt (8) bedeckte Teil (7) des ersten Wellenleiters (3) gewickelt ist.

6. System nach Anspruch 5, bei dem der Krümmungsradius des gewickelten Teils (7) des ersten Wellenleiters (3) größer als 1 mm ist.

7. System nach einem der vorherigen Ansprüche, wobei der Übergang (4) adiabatisch ist.

8. System nach einem der vorherigen Ansprüche, wobei die Laserdiode (1) eine Ausgangsfacette (1b) umfasst, die antireflektiv behandelt wurde.

9. System nach einem der vorherigen Ansprüche, wobei die reflektierende Struktur (5) ein Bragg-Gitter, ein photonisches Kristall, eine Wellenleiterunterbrechung, eine geneigte Facette oder jedwede andere Struktur aufweist, die eine gegen-propagative optische Reflexion zulässt.

**Claims**

1. A system for transmitting an optical signal, comprising a passive optical chip (2) provided, on its upper surface, with a first waveguide (3), and a wideband laser diode (1) disposed on the periphery of said passive optical chip (2), said passive optical chip (2) being provided, on its upper surface, with a reflective structure (5) at the wavelength of said wideband laser diode (1) and with an active or non-linear thin layer portion (8) fed by said laser diode (1) and covering part (7) of said first waveguide (3), said first waveguide (3) being connected to said laser diode (1) by its input end, passing through said reflective structure (5), and comprising a transition (4) between a wide input of said first waveguide disposed at the output of said laser diode (1) and a narrow portion of said first waveguide (3) passing through said reflective structure (5), said passive optical chip (2) being provided, on its upper surface, with a second waveguide (10), a first coupler (13) formed by two first portions (14, 15) of said first waveguide (3), which are not covered by said thin layer portion (8) and which are located on both sides of said thin layer portion (8) along the optical path, and a second coupler (16) formed by two second portions (17, 18) of said first and second waveguides (3, 10), respectively, which are not covered by said thin layered portion (8).

2. The system according to claim 1, wherein the input and output ends of said first and second waveguides (3, 10) opening out onto an edge of said passive optical chip (2) are disposed on the same edge of said passive optical chip (2).

3. The system according to claim 1 or 2, wherein the input and output ends of said first and second waveguides (3, 10) opening out onto an edge of said optical chip (2) are disposed at a distance from said laser diode (1).

4. The system according to any one of the preceding claims, wherein said passive optical chip (2) is provided, on its upper surface, with a third waveguide (21), a third coupler (24) formed by two third portions (25, 26) of said second and third waveguides (10, 24), respectively, which are not covered by said thin layered portion (8), and a balanced detection module (26) connected to the output ends of said second and third waveguides (10, 24) at the edge of said passive optical chip (2).

5. The system according to any one of the preceding claims, wherein said part (7) of said first waveguide (3), which is covered by said thin layered portion (8), is wound.

6. The system according to claim 5, wherein the curvature radius of said wound part (7) of said first waveguide (3) is greater than 1 mm.

7. The system according to any one of the preceding claims, wherein said transition (4) is adiabatic.

8. The system according to any one of the preceding claims, wherein said laser diode (1) comprises an output facet (1b) that has received anti-reflective treatment.

9. The system according to any one of the preceding claims, wherein said reflective structure (5) comprises a Bragg grating, a photonic crystal, an interruption of waveguides, an inclined facet, or any other structure allowing counter-propagating optical reflection.

FIG.1

FIG.2

FIG.3

FIG.4

FIG.5

FIG.6

FIG.7

FIG.8

FIG.9

FIG.10

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **V. DONZELLA et al.** Ion-exchanged Er3+/Yb3+ co-doped waveguide amplifiers longitudinally pumped by broad area lasers. *OPTICS EXPRESS,* 28 Mai 2010, vol. 18 (12), 12690